Europäisches Patentamt

European Patent Office

Office européen des brevets

(11) Veröffentlichungsnummer: **0 354 468**
**A2**

## (12) EUROPÄISCHE PATENTANMELDUNG

(21) Anmeldenummer: 89114320.8

(22) Anmeldetag: 03.08.89

(51) Int. Cl.4: **B60Q 1/30 , H01L 25/13 , F21Q 1/00**

(30) Priorität: 10.08.88 DE 3827083

(43) Veröffentlichungstag der Anmeldung:
14.02.90 Patentblatt 90/07

(84) Benannte Vertragsstaaten:
**DE ES FR GB IT**

(71) Anmelder: TELEFUNKEN electronic GmbH
Theresienstrasse 2
D-7100 Heilbronn(DE)

(72) Erfinder: Schairer, Werner, Dr.
Masurenweg 1
D-7102 Weinsberg(DE)

(74) Vertreter: Maute, Hans-Jürgen, Dipl.-Ing.
TELEFUNKEN electronic GmbH
Theresienstrasse 2
D-7100 Heilbronn(DE)

(54) **Flächenhafter Strahler.**

(57) Die Erfindung betrifft einen flächenhaften Strahler und besteht darin, daß eine transparente Montageplatte mit Leitbahnstruktur vorgesehen ist, auf der eine Vielzahl mit der Leitbahnstruktur in Verbindung stehender Lumineszenz-Halbleiterkörper in einer flächenhaften Verteilung befestigt ist. Jeder Halbleiterkörper ist dabei von einem Reflektor umgeben, wobei die Reflektoren auf der Montageplatte angeordnet sind und das von den Halbleiterkörpern emittierte Licht durch die Montageplatte reflektieren.

FIG.1

EP 0 354 468 A2

# Flächenhafter Strahler

Die Erfindung betrifft einen flächenhaften Strahler. In flächenhaften Strahlern, beispielsweise Kfz-Leuchten, werden in der Regel Glühlampen, meist zusammen mit einem Reflektor, eingesetzt. Glühlampen besitzen aber nur eine begrenzte Lebensdauer, zudem hat man, bedingt durch die Abmessungen der Birne, eine relativ große Bautiefe.

Lumineszenzdioden haben demgegenüber den Vorteil, daß sie eine größere Lebensdauer besitzen und daher zuverlässiger arbeiten, daß sie einen besseren elektro-optischen Wirkungsgrad und deshalb geringeren Energiebedarf aufweisen und daß wegen ihrer flachen Struktur kleinere Bautiefen möglich sind. Lumineszenzdioden werden daher bevorzugt dort eingesetzt, wo ein Austausch einzelner Lampen umständlich und teuer ist und wo hohe Anforderungen an die Zuverlässigkeit, Sicherheit und Langzeitstabilität des Strahlers gestellt werden.

Aus der Zeitschrift "elektronik industrie" 6, 1987, Seite 43 - 44, sind Strahler für Rotsignale mit Höchstleistungs-LEDs bekannt, die elektrische Anschlüsse in konventioneller Senkrechtstreifentechnik aufweisen, d. h. die Richtung der LED-Anschlüsse steht senkrecht auf der großen Fläche der ursprünglichen Halbleiterscheibe, aus der der LED-Körper herausgeschnitten wurde. Diese LEDs können mittels einer Platine in Reihe geschaltet werden.

Diese Strahler besitzen jedoch den Nachteil, daß die Lichtausbeute nicht optimal ist, daß die Anschlüsse als Senkrechtstreifen recht aufwendig hergestellt werden müssen und daß keine besonders flache Bauweise möglich ist.

Der Erfindung liegt die Aufgabe zugrunde, diese Nachteile zu vermeiden und einen Strahler anzugeben, der kostengünstig, mit hohem Wirkungsgrad und in flacher Bauweise hergestellt werden kann.

Dies wird erfindungsgemäß dadurch erreicht, daß eine transparente Montageplatte mit Leitbahnstruktur vorgesehen ist, auf der eine Vielzahl mit der Leitbahnstruktur in Verbindung stehender Lumineszenz-Halbleiterkörper in einer flächenhaften Verteilung befestigt ist, und daß jeder Halbleiterkörper von einem Reflektor umgeben ist, der den von dem Halbleiterkörper emittierten, auf den Reflektor auftreffenden Lichtanteil durch die Montageplatte reflektiert.

Die Reflektoren sind in einer den jeweiligen Bedürfnissen entsprechenden Anzahl gleichmäßig verteilt auf der Montageplatte angebracht. Bei einer geforderten hohen Strahlungsleistung grenzen die Reflektoren dicht aneinander, so daß die Fläche der Montageplatte optimal ausgenutzt wird.

Weitere vorteilhafte Ausgestaltungen der Erfindung ergeben sich aus den Unteransprüchen.

Dadurch, daß die Montage und die Kontaktierung der Lumineszenz-Halbleiterkörper auf einer Platte erfolgt, werden keine Senkrechtstreifen für die Anschlüsse benötigt, so daß ein preiswertes Herstellungsverfahren bei gleichzei tig reduzierter Bautiefe möglich ist. Die hohe Lichtstromnutzung, die wirksame Lichtbündelung und die einfache Ausbildung der Reflektoren bedingt einen hohen Wirkungsgrad des Strahlers, verbunden mit einem relativ geringen Energieverbrauch.

Der erfindungsgemäße Strahler und seine Ausführungsformen sollen nun anhand der Figuren 1 -4 beschrieben werden. Es zeigen:

Figur 1 Eine Schnittdarstellung des flächenhaften Strahlers, bei dem die als Vollform ausgebildeten Reflektoren unterhalb der transparenten Montageplatte angebracht sind.

Figur 2 Eine Schnittdarstellung des flächenhaften Strahlers, bei dem die als Hohlform ausgebildeten Reflektoren unterhalb der transparenten Montageplatte angebracht sind.

Figur 3 Eine Schnittdarstellung des flächenhaften Strahlers, bei dem die als Vollform ausgebildeten Reflektoren sowohl unterhalb als auch oberhalb der transparenten Montageplatte angeordnet sind.

Figur 4 Eine Aufsicht auf die Montageplatte mit Leitbahnstruktur und Halbleiterkörpern.

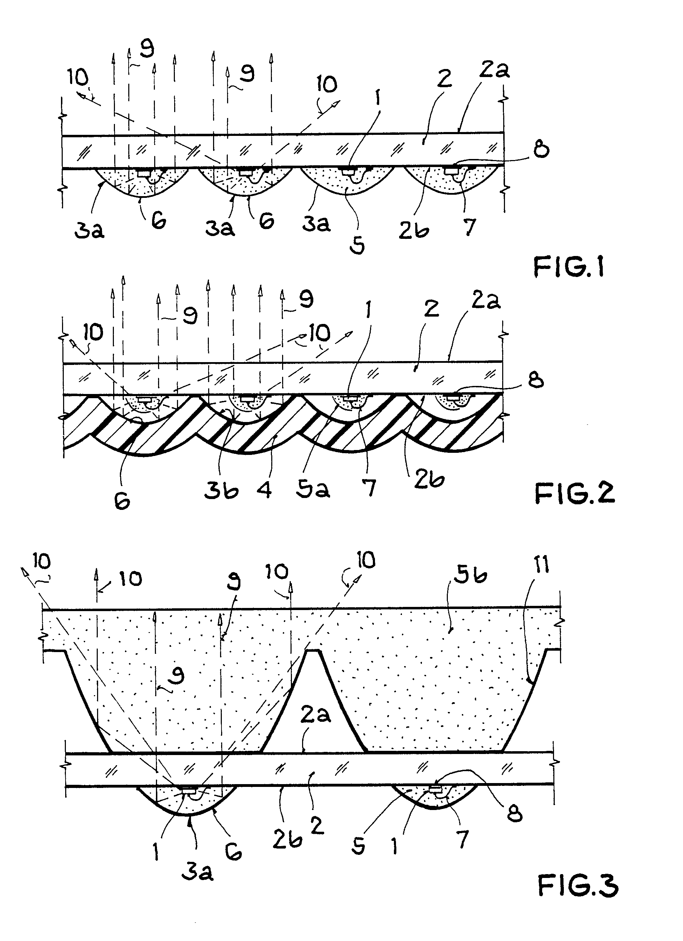

Das Herstellungsverfahren und die Wirkungsweise des erfindungsgemäßen flächenhaften Strahlers wird anhand des Ausführungsbeispiels in Figur 1 erläutert.

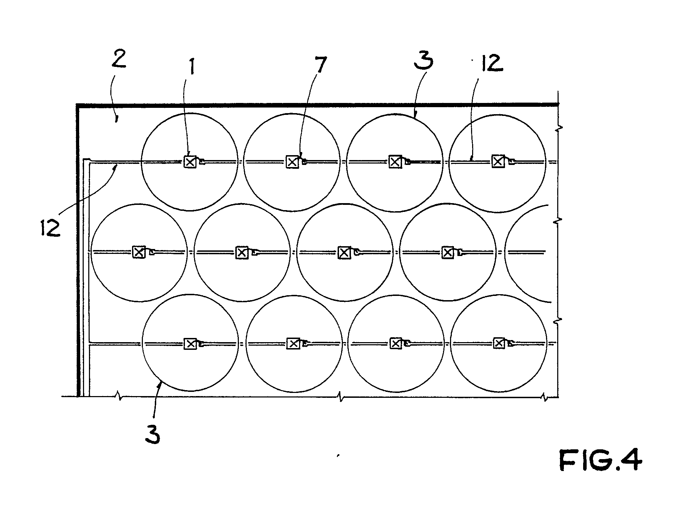

Auf die transparente Montageplatte 2, beispielsweise eine Glasplatte, werden mittels des bekannten photoli thographischen Verfahrens Leitbahnen 12 aufgebracht, die gemäß Figur 4 zur Kontaktierung und Zusammenschaltung der Halbleiterkörper 1 dienen.

Die Halbleiterkörper 1, die beispielsweise eine Ausdehnung von 250 $\mu$ x 250 $\mu$ besitzen, werden, vorzugsweise durch automatische Bestückung, auf die Montageplatte 2 aufgeklebt oder aufgelötet und durch Bonddrähte 7 mit den Leitbahnen 12 verbunden. Zur Herstellung der Reflektoren 3a wird eine Gießform, die beispielsweise die gleiche Form wie dem Formkörper 4 in Fig. 2 besitzen kann, mit einer Kunststoff-Vergußmasse, beispielsweise Siliconharz, Epoxidharz, Polyimid oder Polyphenylensulfid ausgegossen. Die transparente Montageplatte 2 mit Leitbahnstruktur 12 und den darauf befestigten Halbleiterkörpern 1 wird in die Vergußmasse so eingetaucht, daß sich jeder Halbleiterkörper 1 im Brennpunkt des vorzugsweise parabolischen Kunststoffkörpers 5 befindet.

Nach dem Härten der Verußmasse und der Entformung durch die Entfernung der Gießform kann die Außenfläche 6 des Kunststoffkörpers zur Bildung der Reflektoren 3a mittels eines hochreflektierenden Materials, beispielsweise durch Aluminium oder Silber beschichtet werden. Durch die parabolische Form des Reflektors wird die gesamte reflektierte Strahlung 9 parallel gebündelt, so daß man die größtmögliche Lichtstärke erhält. Um eine gute Transmission der Strahlung 9 ohne Reflexion und Brechung an der Grenzfläche Reflektor/Montageplatte sicherzustellen, sollte der Kunststoffkörper 5 in etwa den gleichen Brechungsindex wie die transparente Montageplatte 2 aufweisen. Eine Glasplatte hat beispielsweise einen Brechungsindex von ca. 1,5.

Falls die Gießform z.B. aus Stabilitätsgründen oder als Schutz für die reflektierenden Flächen benötigt wird, wird sie nach dem Aushärten der Verußmasse nicht entfernt. Die Innenseite der Gießform ist dann hochreflektierend ausgebildet, wozu sie vor dem Einbringen der Verußmasse beispielsweise mit einem hochreflektierenden Material beschichtet werden kann.

Die direkte Strahlung 10 ist, im Gegensatz zur reflektierten Strahlung 9, nicht parallel gebündelt sondern isotrop verteilt, so daß sie nur in geringem Maße zu einer Erhöhung der Lichtstärke beiträgt. Daher wird die Kontaktfläche 8 auf der Rückseite des Halbleiterkörpers möglichst hochreflektierend ausgebildet. Dies bedingt, daß die in Richtung Montageplatte emittierte Strahlung 10 größtenteils reflektiert wird und zu der direkt in Richtung Reflektor emittierten und dort reflektierten Strahlung 9 und somit zur Gesamtemission beiträgt, so daß sich ein hoher Sammelwirkungsgrad ergibt.

In einer anderen Ausführungsform gemäß Figur 2, sind die Reflektoren 3b, vermöge eines Formkörpers 4, als Hohlform ausgebildet. Die Montage und Kontaktierung der Halbleiterkörper 1 auf der Montageplatte 2 wird genauso durchgeführt, wie dies anhand des Ausführungsbeispiels in Figur 1 beschrieben wurde. Um die Strahlungsauskopplung aus dem Lumineszenz-Halbleiterkörper 1 zu verbessern, werden die Halbleiterkörper mit einem Kunstharz 5a, der einen Brechungsindex von ca. 1,5 besitzt, betropft. Anschließend wird die Montageplatte 2 ohne Vergießen mit dem Formkörper 4 verbunden. Die Innenseite 6 des Formkörpers ist hochreflektierend und kann beispielsweise vor dem Zusammenschluß mit der Montageplatte mit einem hochreflektierenden Material beschichtet werden. Auch hier wird überwiegend nur die mittels des Reflektors 3b reflektierte Strahlung 9 ausgekoppelt.

Bei einer weiteren Ausführungsform wird zunächst ein Strahler gemäß Figur 1 oder 2 als Vollform oder Hohlform ausgebildet und anschließend weitere Reflektoren 11, die mittels separater Gießformen oder Spritzformen hergestellt werden können, beispielsweise vermöge eines optischen Klebers auf der Oberseite 2a der Montageplatte angebracht. Diese zusätzlichen Reflektoren 11, in Figur 3 als Vollform dargestellt, besitzen die Form eines Parabelstumpfs und werden so auf die Oberseite 2a der Montageplatte geklebt, daß die Reflektoren 3a, 11 unterhalb und oberhalb der Montageplatte 2 zusammen ein parabolisches Profil ergeben.

Bei dieser Ausführungsform wird sowohl ein Großteil der nach oben emittierten Strahlung 10 als auch die nach unten emittierte und reflektierte Strahlung 9 gebündelt, so daß die Lichtstärke und der Lichtnutzungsgrad ansteigt.

In Figur 3 bestehen die Kunststoffkörper 5b der Reflektoren 11 oberhalb der Montageplatte vorzugsweise aus dem gleichen Material wie die Kunststoffkörper 5 der Reflektoren 3a unterhalb der Montageplatte. Die oberen Reflektoren 11 besitzen daher den gleichen Brechungsindex wie die transparente Montageplatte und ermöglichen somit eine gute Transmission der Strahlung ohne zusätzliche Reflexion oder Brechung an der Grenzfläche Montageplatte/Reflektor.

In Figur 4 ist die Kontaktierung und Verdrahtung von Halbleiterkörpern 1 auf der Montageplatte 2 dargestellt. Je nach Erfordernissen und Spezifikation können mehrere Halbleiterkörper 1 auf der gesamten zu Verfügung stehenden Fläche der Montageplatte angebracht und zur Erhöhung der Betriebsspannung hintereinander geschaltet und/oder zur Erzielung der notwendigen Lichtstärke parallel geschaltet werden. Diese Zusammenschaltung ist dabei gemäß des vorgegebenen Layouts der Leitbahnstruktur 12 beliebig variierbar.

Vorzugsweise werden die Halbleiterkörper 1 derart auf der Montageplatte 2 angeordnet, daß für bestimmte Anforderungen eine maximale Lichtstärke erzielt wird. Dazu können beispielsweise die Reflektoren 3 dicht aneinandergrenzen und so den auf der Montageplatte zur Verfügung stehenden Platz optimal ausnützen.

Die Zahl der verwendeten Lumineszenzdioden, deren Verschaltung sowie die Wellenlänge der emittierten Strahlung kann dabei exakt nach den spezifischen Anforderungen vorgegeben werden und ohne weiteres auch in den infraroten Bereich, z. B. durch Bestückung mit GaAs-Dioden, verschoben werden.

Die verwendeten Lumineszenzdioden besitzen typischerweise eine Flußspannung von 2 V und eine zulässige Stromstärke von 50 mA, so daß beispielsweise für eine Betriebsspannung von 12 V ca. 5 - 6 Dioden hintereinander geschaltet werden müssen.

Der Lichtstrom einer Einzel-Lumineszenzdiode beträgt typischerweise 1 - 4 lm, die Lichtstärke ca. 1 - 3 cd; für eine Kfz-Bremsleuchte beispielsweise muß die Lichtstärke zwischen 40 cd und 100 cd liegen.

Um beispielsweise Rotlicht-emittierende Strahler zu erhalten, können GaAlAs-Heterostrukturdioden eingesetzt werden, deren maximale Emission bei 660 nm liegt.

Der erfindungsgemäße Strahler ist vielfältig einsetzbar; denkbar ist beispielsweise die Verwendung als Kfz-Leuchte, Signalleuchte, Begrenzungsleuchte oder in Ampeln.

**Ansprüche**

1) Flächenhafter Strahler, dadurch gekennzeichnet, daß eine transparente Montageplatte (2) mit Leitbahnstruktur (12) vorgesehen ist, auf der eine Vielzahl mit der Leitbahnstruktur (12) in Verbindung stehender Lumineszenz-Halbleiterkörper (1) in einer flächenhaften Verteilung befestigt ist, und daß jeder Halbleiterkörper (1) von einem Reflektor (3) umgeben ist, der den von dem Halbleiterkörper emittierten, auf den Reflektor (3) auftreffenden Lichtanteil durch die Montageplatte (2) reflektiert.

2) Flächenhafter Strahler nach Anspruch 1, dadurch gekennzeichnet, daß die Reflektoren (3) gleichmäßig verteilt auf der Montageplatte (2) angeordnet sind.

3) Flächenhafter Strahler nach Anspruch 1, dadurch gekennzeichnet, daß die Reflektoren (3) dicht aneinandergrenzend unter optimaler Ausnutzung der Fläche auf der Montageplatte (2) angeordnet sind.

4) Flächenhafter Strahler nach einem der vorangehenden Ansprüche, dadurch gekennzeichnet, daß jeder Halbleiterkörper (1) an der Unterseite (2b) der transparenten Montageplatte in einem Kunststoffkörper (5) eingebettet ist.

5) Flächenhafter Strahler nach Anspruch 4, dadurch gekennzeichnet, daß die Außenflächen (6) der Kunststoffkörper hochreflektierend ausgebildet sind.

6) Flächenhafter Strahler nach Anspruch 4, dadurch gekennzeichnet, daß die Kunststoffkörper (5) von einer Gießform umgeben sind, deren Innenseite die Reflektoren bildet.

7) Flächenhafter Strahler nach Anspruch 4-6, dadurch gekennzeichnet, daß der Brechungsindex des Kunststoffkörpers (5) in etwa so groß wie der Brechungsindex der transparenten Montageplatte (2) ist.

8) Flächenhafter Strahler nach Anspruch 1 oder 2, dadurch gekennzeichnet, daß die Halbleiterkörper (1) an der Unterseite (2b) der transparenten Montageplatte angebracht und von einem Formkörper (4) umgeben sind, dessen Innenseite (6) die Reflektoren (3b) bildet und sich zwischen Kunststoffkörper (5) und Formkörper (4) Luft befindet.

9) Flächenhafter Strahler nach einem der vorangehenden Ansprüche, dadurch gekennzeichnet, daß die Reflektoren (3a, 3b) parabolisch geformt sind, wobei jeweils ein Halbleiterkörper (1) im Brennpunkt eines Reflektors (3a, 3b) angeordnet ist.

10) Flächenhafter Strahler nach einem der vorangehenden Ansprüche, dadurch gekennzeichnet, daß an der Oberseite (2a) der transparenten Montageplatte zusätzliche Reflektoren (11) angebracht sind, die als Parabelstumpf ausgebildet sind und zusammen mit den Reflektoren (3a, 3b) an der Unterseite (2a) der Montageplatte die Struktur eines Paraboloids besitzen.

11) Flächenhafter Strahler nach Anspruch 10, dadurch gekennzeichnet, daß die zusätzlichen Reflektoren (11) an der Oberseite der transparenten Montageplatte als Kunststoffkörper (5b), deren Außenflächen hochreflektieren, ausgebildet sind.

12) Flächenhafter Strahler nach Anspruch 11, dadurch gekennzeichnet, daß der Brechungsindex des Kunststoffkörpers (5b) in etwa so groß wie der Brechungsindex der transparenten Montageplatte (2) ist.

13) Flächenhafter Strahler nach Anspruch 10, dadurch gekennzeichnet, daß die zusätzlichen Reflektoren an der Oberseite der transparenten Montageplatte mittels eines Formkörpers als Hohlform, deren Innenseite hochreflektierend ist, ausgebildet sind.

14) Flächenhafter Strahler nach einem der vorangehenden Ansprüche, dadurch gekennzeichnet, daß die Halbleiterkörper (1) mittels der Leitbahnstruktur (12) auf der transparenten Montageplatte (2) parallel- und/oder hintereinandergeschaltet werden.

15) Verwendung eines flächenhaften Strahlers nach einem der vorangehenden Ansprüche für Kfz-Leuchten, Signalleuchten, Begrenzungsleuchten oder Ampeln.

FIG.1

FIG.2

FIG.3

FIG.4